# EUROPEAN PATENT APPLICATION

(11) **EP 1 369 934 A1**
(43) Date of publication of application: **10.12.2003**
(21) Application number: 02012627.2
(22) Date of filing: 06.06.2002
(51) Int. Cl.: H01L 33/00

(54) **Light emitting diode lamp with light emitting diode module having improved heat dissipation**

(71) Applicant: Unity Opto Technology Co., Ltd., San Chung City, Taipei Hsien, Taiwan (TW)
(72) Inventor: Chin, Yuan-Cheng, Hsintien City, Taipei Hsien, Taiwan (TW)
(74) Representative: Winkler, Andreas, Dr.

(57) **Abstract**

A light emitting diode (LED) lamp includes an LED module having a base plate (2) made of metals. The base plate (2) includes a first section (21) and a second section (22) isolated from each other and respectively connected to positive and negative terminals of a power source. A number of LED units (3) is mounted to and mechanically supported by the base plate (2). Each LED unit (3) includes a light emitting chip (31) mounted on a support frame (32) having positive and negative tabs (321,322) both having predetermined surface areas and soldered to the first (21) and second (22) sections of the base plate (2) whereby electrical connection is formed between the positive and negative tabs (321,322) of the LED unit (3) and the first (21) and second (22) sections of the base plate (2). The metal base plate (2) functions to provide a current path to the LED unit (3) and an effective measure to dissipate heat generated during the operation of the LED module. Thus, large current can be applied to the LED module for enhancing light emission efficiency thereof.

## Description

### FIELD OF THE INVENTION

The present invention generally relates to a light emitting diode (LED) lamp, and in particular to an LED module of the LED lamp having improved heat dissipation.

### BACKGROUND OF THE INVENTION

A light emitting diode (LED) lamp comprises an LED module comprising a substrate made of synthetic materials with conductive patterns formed thereon. A number of LEDs is mounted to the substrate and in electrical connection with the conductive patterns. The LED lamp has advantages of light weight and reduced power consumption. However, the brightness of the light emitted from the LED lamp is inferior to the traditional lamps. This is basically due to the efficiency of the LEDs. Increasing current supplied to the LEDs can effectively enhance the light emission efficiency of the LEDs. This, however, accompanies with substantially increase of heat generated during the operation of the LED module and thus a substantial rise of temperature. The high temperature is harmful to the substrate of the LED module. In addition, the substrate that is made of synthetic material is not able to remove or dissipate the heat quickly. This limits the amount of current that can be supplied to the LEDs. Thus, the brightness of the LED lamp is limited.

It is thus desired to provide an LED module having improved heat dissipation for addressing the above issues.

### SUMMARY OF THE INVENTION

An object of the present invention is to provide an LED module that is capable to give off light of high brightness without undesired side effect.

Another object of the present invention is to provide an LED module that can effectively dissipate heat generated by large electrical current supplied to LEDs.

A further object of the present invention is to provide an LED module that is capable to take large current for giving off bright light.

To achieve the above objects, in accordance with the present invention, there is provided a light emitting diode (LED) lamp comprising an LED module having a base plate made of metals. The base plate comprises a first section and a second section isolated from each other and respectively connected to positive and negative terminals of a power source. A number of LED units is mounted to and mechanically supported by the base plate. Each LED unit comprises a light emitting chip mounted on a support frame having positive and negative tabs both having predetermined surface areas and soldered to the first and second sections of the base plate whereby electrical connection is formed between the positive and negative tabs of the LED unit and the first and second sections of the base plate. The metal base plate functions to provide a current path to the LED unit and an effective measure to dissipate heat generated during the operation of the LED module. Thus, large current can be applied to the LED module for enhancing light emission efficiency thereof

### BRIEF DESCRIPTION OF THE DRAWINGS

The present invention will be apparent to those skilled in the art by reading the following description of the preferred embodiments thereof, with reference to the attached drawings, in which:

Figure 1 is a perspective view of a light emitting diode (LED) module constructed in accordance with a first embodiment of the present invention;

Figure 2 is an exploded view of the LED module of the first embodiment of the present invention;

Figure 3 is a perspective view of a lamp module incorporating the LED module of the present invention;

Figure 4 is a perspective view of an LED module constructed in accordance with a second embodiment of the present invention;

Figure 5 is a perspective view of an LED module constructed in accordance with a third embodiment of the present invention; and

Figure 6 is a plan view of an LED module constructed in accordance with a fourth embodiment of the present invention.

### DETAILED DESCRIPTION OF THE PREFERRED EMBODIMENTS

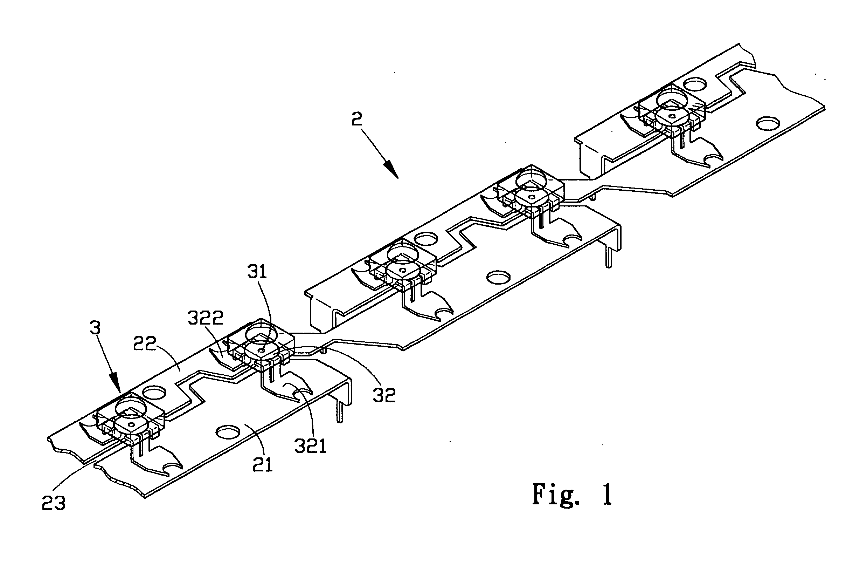

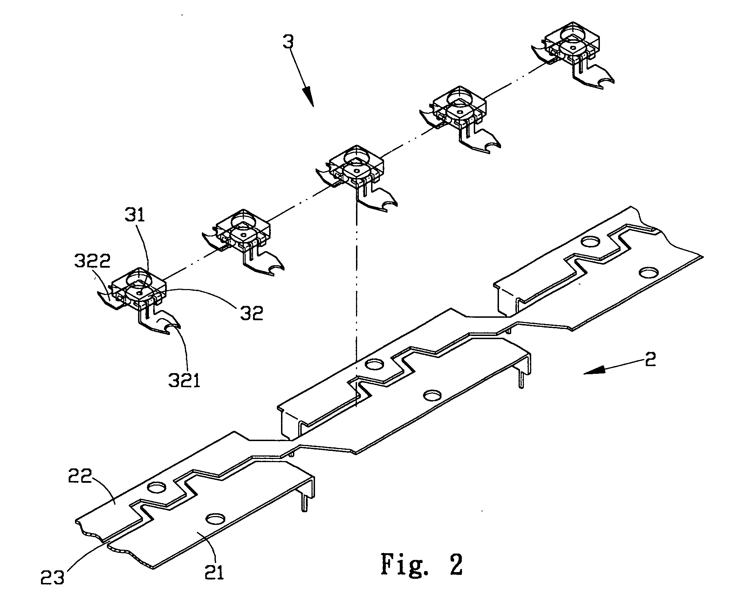

With reference to the drawings and in particular to Figures 1-3, a light emitting diode (LED) module of an LED lamp constructed in accordance with a first embodiment of the present invention comprises a base plate 2 made of an electrically and thermally conductive material, such as metals in the embodiment illustrated, comprised of a first section 21 and a second section 22 isolated from each other by an insulation 23 which can any suitable insulation material or simply an air gap as shown in the drawings. The first and second sections 21, 22 are respectively in electrical connection with positive and negative terminals of a power source (not shown).

At least one, preferably a number of, light emitting diode (LED) unit 3 is mounted to the base plate 2. Each LED unit 3 comprises a light emitting chip 31 mounted on a support frame 32. The support frame 32 has a positive tab 321 and a negative tab 322 both having predetermined surface areas for being respectively in surface contact with the first and second sections 21, 22 of the base plate 2. The positive and negative tabs 321, 322 are soldered or spot-welded to the first and second sections 21, 22 of the base plate 2. Thus, the LED unit 3 is mechanically supported by and electrically connected to the first and second sections 21, 22 of the base plate 2.

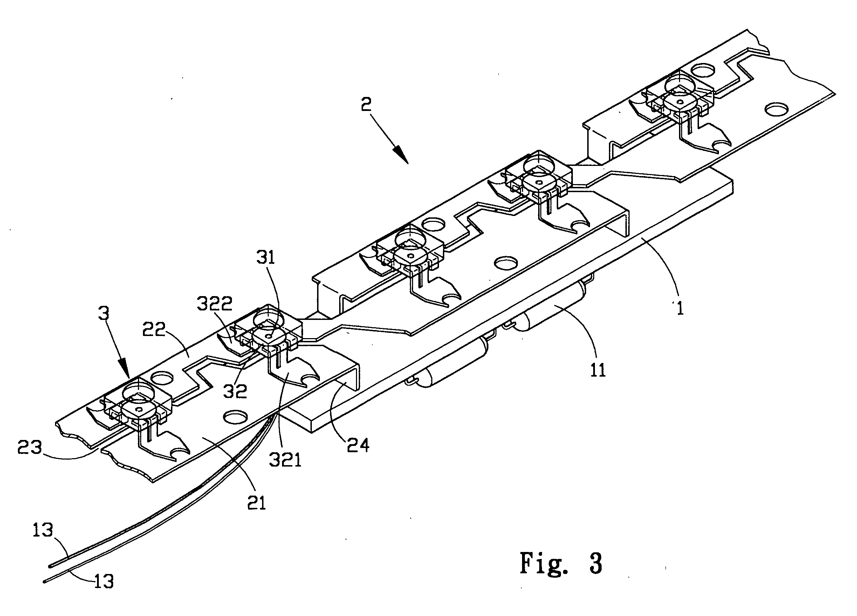

To be incorporated in the LED lamp, an LED lamp module, as shown in Figure 3, may comprise a mount 1 which the base plate 2 of the LED module is fixed to and supported by . Such a mount 1 can be a printed circuit board on which electrical elements 11, such as resistors, and conductive patterns are formed A number of legs 24, which are preferably conductive members, extend between the mount 1 and the first and second sections 21, 22 of the base plate 2 for firmly supporting the base plate 2 on the mount 1. Wires 13 connect the first and second sections 21, 22 of the base plate 2 to the positive and negative terminals of the power source.

It is noted that the base plate that is made of metal in the embodiment illustrated provides an excellent path for electrical current to the LED units 3. The metal can bear much higher temperature than the synthetic board employed in the traditional LED lamps. In addition, the metal plate serves as a heat dissipation member that effectively removes heat generated during the operation of the LED module. Thus, a large current can be supplied to the LED units 3 for bright light without causing undesired high temperature and other side effect.

It is apparent to those having ordinary skills to mount electrical elements, such as resistors and capacitors, on the base plate 2 to provide other functions.

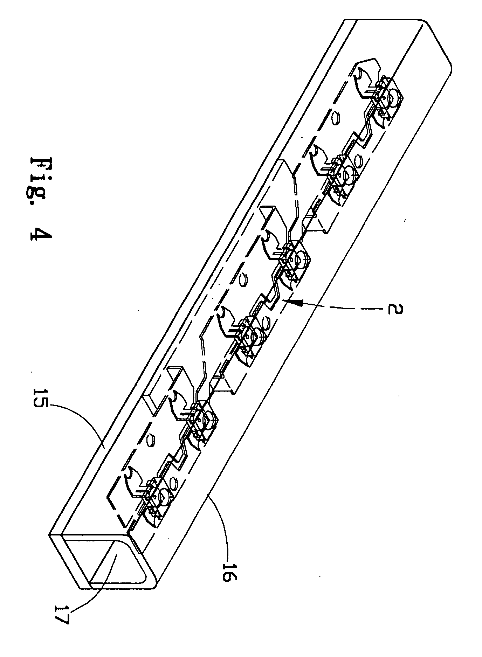

If desired and as illustrated in a second embodiment of the present invention shown in Figure 4, a casing 15 comprising at least a light-transmitting portion 16 and defining an interior space 17 is provided for housing the LED module of the present invention. The LED module is received and retained in the interior space 17 and shielded by the casing 15. Light emitted from the LED module transmits through the light-transmitting portion 16 of the casing 15.

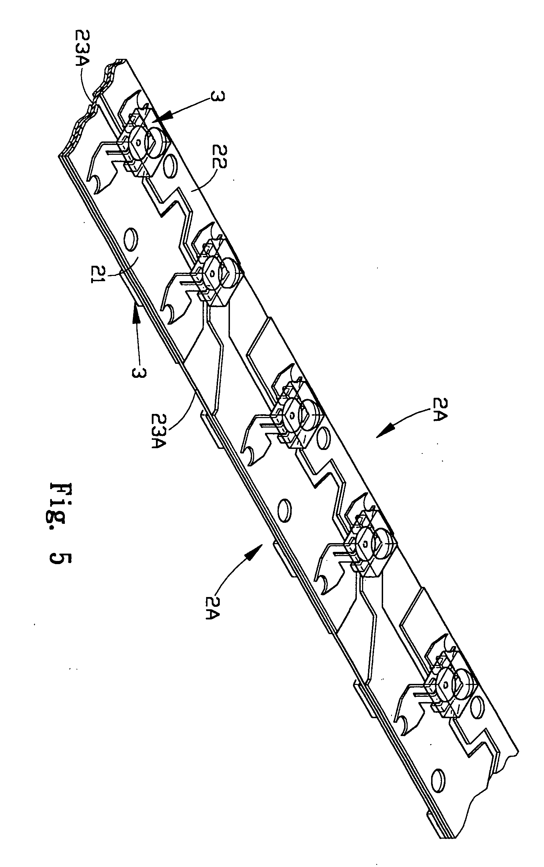

Figure 5 shows an LED module constructed in accordance with a third embodiment of the present invention, comprising a base plate 2A comprising an insulation layer 23A having opposite surfaces. Each of the first and second sections 21, 22 comprises two or more metal boards mounted to both surfaces of the insulation layer 23A, forming a sandwiched structure. LED units 3 are mounted between the metal boards 21, 22 with the metal boards 21, 22 respectively connected to positive and negative terminals of a power source (not shown). By being mounted to the insulation layer 23A, the metal boards or sections 21, 22 are properly spaced from and thus isolated from each other.

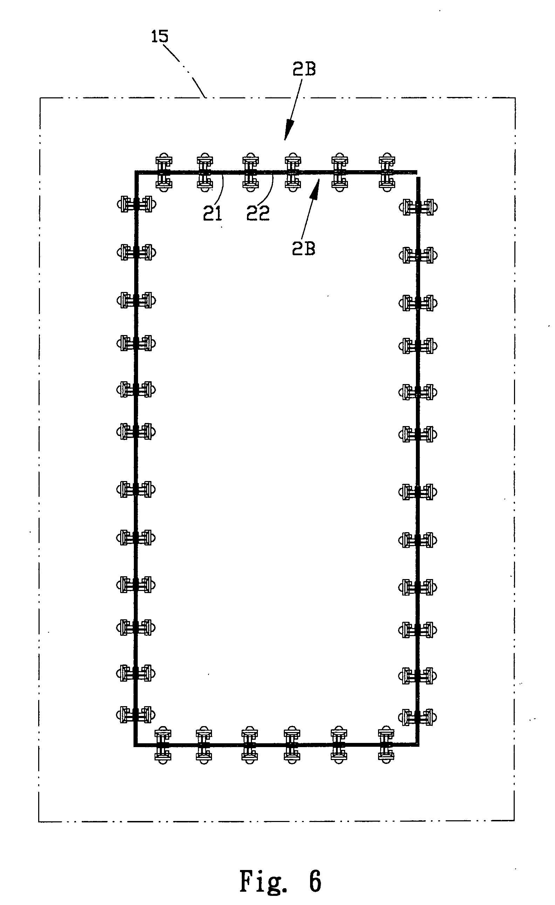

Figure 6 shows an LED module constructed in accordance with a fourth embodiment of the present invention wherein a base plate 2B is comprised of a number of metal boards 21, 22 and is arranged in the form of a rectangular frame with the metal boards 21, 22 facing transversely. LED units 3 are mounted between the metal boards 21, 22 for emitting light in the outward and inward directions. The LED module is housed in a casing 15.

To this point, it shows that two metal members 21, 22 to which positive and negative terminals of LED units 3 are respectively mounted provide a path for electrical current that is capable to take larger current whereby light emission efficiency of the LED module unit 3 can be enhanced. In addition, heat can be effectively dissipated through the metal members 21, 22.

Although the present invention has been described with reference to the preferred embodiments thereof, it is apparent to those skilled in the art that a variety of modifications and changes may be made without departing from the scope of the present invention which is intended to be defined by the appended claims.
The features disclosed in the foregoing description, in the claims and/or the accompanying drawings may, both separately and in any combination thereof be, be material for realising the invention in diverse forms thereof.

## Claims

1. A light emitting diode module comprising:
a base plate made of an electrically and thermally conductive material, comprising a first section and a second section isolated from each other by insulation means therebetween, the first and second sections being adapted to connect to positive and negative terminals of a power source; and
at least one light emitting diode unit comprising a light emitting chip mounted on a support frame, the support frame having a positive tab and a negative tab both having predetermined surface areas, the positive and negative tabs being respectively mounted to, mechanically supported and electrically connected to the first and second sections of the base plate.

2. The light emitting diode module as claimed in Claim **1**, wherein the insulation means comprises an air gap between the first and second sections.

3. The light emitting diode module as claimed in Claim **1** further comprising a casing housing the base plate and the light emitting diode unit mounted on the base plate, the casing having at least a light transmitting portion for transmission of light emitted from the light emitting diode unit.

4. The light emitting diode module as claimed in Claim **1**, wherein the base plate comprises a composite structure comprising at least one insulation layer, each of the first and second sections comprising a plurality of electrically and thermally conductive members attached to opposite sides of each insulation layer.

5. The light emitting diode module as claimed in Claim **1**, wherein the base plate comprises at least two segments forming an includes therebetween, each segment comprising at least one light emitting diode unit whereby light from the light emitting diode units are transmitted in different directions.

6. The light emitting diode module as claimed in Claim **5**, wherein the base plate comprises four segments forming a rectangular frame.

7. The light emitting diode module as claimed in Claim **1**, wherein the first and second sections of the base plate are attached to and supported by a mount.

8. The light emitting diode module as claimed in Claim **7**, wherein the mount comprises a printed circuit board, support legs extending between the sections and the printed circuit board.

9. The light emitting diode module as claimed in Claim **1**, wherein the positive and negative tabs of the support frame of each light emitting diode unit are mounted to the first and second sections by spot welding.

10. The light emitting diode module as claimed in Claim **1**, wherein the base plate comprises electrical elements selectively mounted to the first and second sections of the base plate.

11. The light emitting diode module as claimed in Claim **1**, wherein the electrically and thermally conductive material comprises metals.
